# EUROPEAN PATENT APPLICATION

(11) **EP 0 989 790 A1**
(43) Date of publication of application: **29.03.2000**
(21) Application number: 98203262.5
(22) Date of filing: 22.09.1998
(51) Int. Cl.: H05K 3/00, H05K 3/06, C23F 1/08

(54) **Apparatus and method for the treatment of substrates with an etching liquid**

(71) Applicant: AGFA-GEVAERT N.V., 2640 Mortsel (BE)
(72) Inventor: Verlinden, Bart, c/o Agfa-Gevaert N.V., 2640 Morstel (BE); Willaert, Peter, c/o Agfa-Gevaert N.V., 2640 Mortsel (BE)

(57) **Abstract**

The apparatus comprises a housing (10) and an etching cell (12) within the housing (10) having an entrance opening (14) and an exit opening (16) each closed by a pair of path-defining rollers (18) urged towards each other to form a nip (20) there-between through which a transport path (22) for substrates (46) extends. Drive means (24) are provided for driving substrates (46) along the transport path (22). The etching cell (12) is a closed etching cell (12) and sealing means (26) are provided for sealing each path-defining roller (18) to the housing (10).

## Description

### FIELD OF THE INVENTION

The present invention relates to an apparatus and process for the treatment of substrates, such as glass or metal sheets, with an etching liquid, especially the etching of copper from copper carrying substrates such as printed circuit boards.

### BACKGROUND OF THE INVENTION

Etchants are liquid chemical solutions used, for example, to create copper circuit patterns on printed circuit boards (PCBs). They etch away the copper in the exposed regions not protected by an etch resist. In the case of PCBs, the copper pattern remaining is the desired circuitry that has been protected from the etching liquid either by a photoresist layer, screened resist or by an etch resistant plating such as tin-lead (solder plate), tin-nickel, tin or gold. Etching is also performed to prepare the surface of the copper for inner layer oxide coating or plating. This operation requires minimal metal removal and is called micro-etching.

The major etching liquids used to remove unwanted copper from PCB imaging are alkaline ammonia, sulphuric-peroxide, cupric chloride, persulphates, and ferric chloride.

In a known apparatus for the treatment of printed circuit boards with an etching liquid, a spray chamber is defined within a housing having an entrance opening and an exit opening each closed by a roller pair between which a transport path for printed circuit boards extends.

Whatever etching chemistry is used, a uniform etch with straight side walls is desirable. While the use of a constantly refreshed etching liquid spray has formerly been used, we have found that it is difficult to control the spraying technique in such a manner as to achieve really uniform results. This is thought to be due to unpredictable interactions occurring between the etching liquid and the atmosphere in the spray chamber.

### OBJECTS OF INVENTION

It is an object of the present invention to provide an apparatus and method for the etching of substrates with an etching liquid which enables uniform results to be achieved.

### SUMMARY OF THE INVENTION

We have now found that this objective, and other useful benefits, can be achieved, by the use of a closed etching cell in which sealing means are provided for sealing each path-defining roller to the housing.

According to a first aspect of the invention, there is provided an apparatus for the treatment of substrates with an etching liquid, comprising a housing, an etching cell within the housing having an entrance opening and an exit opening each closed by a pair of path-defining rollers urged towards each other to form a nip there-between through which a transport path for substrates extends, and drive means for driving substrates along the transport path, characterised in that the etching cell is a closed etching cell and sealing means are provided for sealing each path-defining roller to the housing.

According to a second aspect of the invention there is provided a method for the treatment of a substrate with an etching liquid, comprising driving a substrate along a transport path through an apparatus comprising a housing, and an etching cell within the housing having an entrance opening and an exit opening each closed by a pair of path-defining rollers urged towards each other to form a nip there-between through which the transport path extends, characterised by sealing each path-defining roller to the housing to ensure the etching cell is a closed etching cell.

The housing preferably includes an inlet for the introduction of etching liquid into the etching cell and an outlet for the discharge of used etching liquid from the etching cell. A major consideration in using etching liquids, and in the etching operation, is regeneration.

The etching solution is preferably stabilised for optimum performance and spent etching liquid regenerated as it cycles through the apparatus. This is usually accomplished by replenishment of the liquid. A portion of the spent liquid is continuously removed from the outlet of the cell and processed for re-use by extracting dissolved copper through chemical or electrolytic means. The condition of the etching liquid may be monitored by measuring its specific gravity.

The etching liquid may be selected from "alkaline ammonia", "sulphuric-peroxide", "cupric chloride", "persulphates", and "ferric chloride".

"Alkaline ammonia" is the most preferred etching liquid, comprising an aqueous composition of ammonia, with ammonium chloride, bicarbonate, phosphate and nitrate.

"Sulphuric-peroxide" etching liquids are basically a composition of hydrogen peroxide, sulphuric acid, copper sulphate, phosphoric acid, aryl sulphonic acids and thiosulphates.

"Cupric chloride" etching liquid is basically an aqueous composition of cupric chloride and hydrochloric acid. A mixture of sodium chlorate, sodium chloride and hydrochloric acid may be used as a replenishing liquid for cupric chloride etching liquids.

A solution of a mixture of ammonium, sodium and potassium persulphates, or an aqueous composition of ferric chloride and hydrochloric acid provide further useful etching liquids.

Most etching liquids are corrosive to many common metals. It is therefore preferred that those parts of the apparatus which come into contact with the etching liquid, or its vapour, are formed of a plastics material such as polyvinyl chloride or polypropylene.

The apparatus may further comprise means defining an etching liquid level in the cell, so positioned that the transport path extends at least in part through the etching liquid below the liquid level.

A liquid sensor may be provided in the cell for this purpose, but where the housing includes an outlet for the discharge of used etching liquid from the cell, this outlet may define the liquid level in the cell. The etching liquid may completely fill the cell, or alternatively the liquid level may be defined to leave a gas space there-above. In the latter arrangement, means may be provided to supply an atmosphere having a controlled composition to the gas space.

Particularly in the case of alkaline ammonia, the presence of carbon dioxide in the gas space is a disadvantage. The carbon dioxide reacts with the ammonia, thereby consuming the latter and raising the pH of the liquid. The atmosphere having a controlled composition preferably comprises a reduced level of carbon dioxide, such as less than 0.02% by volume.

The atmosphere having a controlled composition preferably comprises additional oxygen, such as at least 22% oxygen by volume. The presence of oxygen encourages the oxidation of the copper metal to a soluble form.

Most preferably the atmosphere having a controlled composition preferably comprises is a mixture of oxygen and nitrogen.

The copper foil carried on a PCB typically has a thickness of about 30 µm. To fully etch through this copper layer, the etching process can be carried out at a temperature of from 20°C to 65°C, with a residence time of for example from 20 seconds to 2 minutes. The etching cell, or the circuit for recycling the etching liquid, may include a heating device and temperature sensors to control the temperature of the etching liquid. The drive device for driving the substrate through the etching cell may include a speed control device coupled to the temperature sensor, to control the residence time of the substrate in the etching cell in response to the temperature of the etching liquid.

In preferred embodiments of the invention, each path-defining roller comprises a rigid non-metallic core having a covering of elastomeric material. The materials used for the core and the covering, and the construction of the path-defining rollers may be as described in European patent applications 95203464.3 (Agfa-Gevaert NV), 95203467.6 (Agfa-Gevaert NV), 97200853.6 (Agfa-Gevaert NV) or 97201815.4 (Agfa-Gevaert NV).

A non-metallic core is preferred to reduce corrosion from the etching liquid. Composite materials comprising carbon glass or other fibres embedded in a resin are suitable for the core. The path-defining rollers may be mounted in the housing in a manner similar to that described in European patent application 96200276.2 (Agfa-Gevaert NV).

The sealing arrangement, for each path-defining roller, may be selected from stationary sealing devices and rotatable sealing devices. For example, rotatable sealing devices may be used, each in the form of a sealing roller carried by the housing and in contact with the path-defining roller.

The manner of mounting the sealing rollers in the housing may be similar to that described in European patent applications 95203465.0 (Agfa-Gevaert NV), 97201052.4 (Agfa-Gevaert NV), or 97201814.7 (Agfa-Gevaert NV).

The drive device for driving the substrate through the etching cell may be constituted by the path-defining rollers, when these rollers are drive rollers. Drive may be transmitted from a drive motor to the path-defining rollers, for example as described in European patent application 95203442.9 (Agfa-Gevaert NV).

The etching cell may be preceded or followed by one or more further treatment cells, preferably located within the same housing. For example, the etching cell may be followed by a rinsing cell. Non-functional intermediate cells may be positioned between the treatment cells, to reduce the possible contamination of the fluid contents of one cell with the contents of another.

The apparatus may have a generally horizontal or a generally vertical configuration. In either configuration, a straight path for the substrate is preferred.

### DETAILED DESCRIPTION OF THE INVENTION

The invention will be described by the following illustrative embodiment with reference to the accompanying drawing without the intention to limit the invention thereto, and in which:

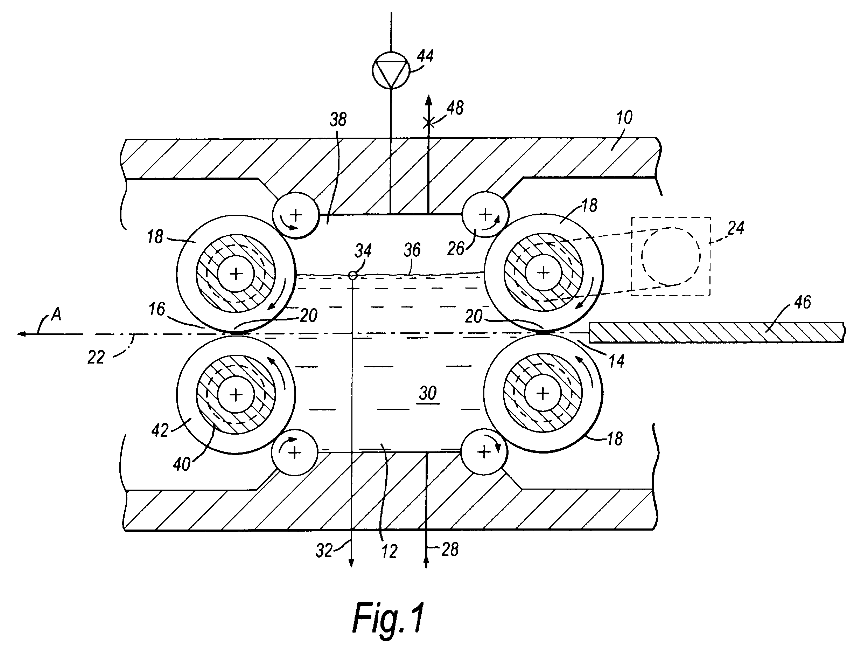

Figure 1 is a schematic representation of an apparatus for the treatment of printed circuit boards with an etching liquid according to the invention.

As shown in the drawings, the apparatus comprises a housing 10 formed of PVC, defining a closed etching cell 12.

The cell 12 has an entrance opening 14 and an exit opening 16, each opening being closed by a pair of path-defining rollers 18. The path-defining rollers 18 of each pair are urged towards each other to form a nip 20 there-between through which a transport path 22 for printed circuit board 46 extends in the direction of the arrow A.

Each path-defining roller 18 comprises a rigid core 40 formed of a non-metallic composite material comprising carbon fibres embedded in resin. The core 40 has a covering 42 of elastomeric material.

For each path-defining roller 18, a titanium sealing roller 26 is provided, carried by the housing 10 and in contact with the associated path-defining roller 18, for sealing the path-defining roller 18 to the housing 10.

A drive motor 24 is provided to drive the path-defining rollers 18 via a coupling mechanism not shown in detail. Preferably, the drive motor 24 is connected to both roller pairs.

The housing 10 includes an inlet 28 for the introduction of etching liquid 30 into the cell 12 and an outlet 32 for the discharge of used etching liquid 30 from the cell 12. The opening 34 of the outlet 32 from the cell 12 defines a liquid level 36 in the cell 12. The transport path 22 extends through the etching liquid 30 below the liquid level 36.

The liquid level 36 is positioned to leave a gas space 38 there-above. A pump 44 is provided to supply an atmosphere having a controlled composition into the gas space 38. A closeable exhaust opening 48 is provided to evacuate the gas space 38.

The apparatus is used as follows. Etching liquid 30 is introduced into the cell 12 through the inlet 28 until the liquid begins to flow through the outlet 32.

An atmosphere having a controlled composition is supplied by the pump 44 into the gas space 38 above the liquid level 36. A printed circuit board 46 is passed along a transport path 22 through the apparatus. Used etching liquid 30 is discharged from the cell 12 through the outlet 32 as fresh etching liquid is introduced into the cell through the inlet 28.

In an example, the printed circuit board 46 comprises a 25µ thick layer of copper. The air exchange in the cell is between 10 and 50 m³ air / kg(Cu)m²Cu. The etching liquid comprises ammonium chloride.

### Reference Number List

housing 10
etching cell 12
entrance opening 14
exit opening 16
path-defining rollers 18
nip 20
transport path 22
drive motor 24
sealing roller 26
inlet 28
etching liquid 30
outlet 32
opening 34
liquid level 36
gas space 38
core 40
covering 42
pump 44
board 46
exhaust opening 48

## Claims

1. An apparatus for the treatment of substrates (46) with an etching liquid (30), comprising a housing (10), an etching cell (12) within said housing (10) having an entrance opening (14) and an exit opening (16) each closed by a pair of path-defining rollers (18) urged towards each other to form a nip (20) there-between through which a transport path (22) for substrates (46) extends, and drive means (24) for driving substrates (46) along said transport path (22), characterised in that said etching cell (12) is a closed etching cell (12) and sealing means (26) are provided for sealing each said path-defining roller (18) to said housing (10).

2. An apparatus according to claim 1, wherein said housing (10) includes an inlet (28) for the introduction of etching liquid (30) into said etching cell (12) and an outlet (32) for the discharge of used etching liquid (30) from said etching cell (12).

3. An apparatus according to claim 1, further comprising level defining means (32) defining an etching liquid level (36) in said etching cell (12), so positioned that said transport path (22) extends at least in part through said etching liquid (30) below said etching liquid level (36).

4. An apparatus according to claim 3, wherein said etching liquid level (36) is defined to leave a gas space (38) there-above.

5. An apparatus according to claim 4, further comprising supply means (44) to supply an atmosphere having a controlled composition to said gas space (38).

6. An apparatus according to claim 1, wherein each said path-defining roller (18) comprises a rigid non-metallic core (40) having a covering (42) of elastomeric material.

7. An apparatus according to claim 1, wherein said sealing means (26), for each said path-defining roller (18), is selected from stationary sealing devices and rotatable sealing devices.

8. A method for the treatment of a substrate (46) with an etching liquid (30), comprising driving a substrate (46) along a transport path (22) through an apparatus comprising a housing (10), and an etching cell (12) within said housing (10) having an entrance opening (14) and an exit opening (16) each closed by a pair of path-defining rollers (18) urged towards each other to form a nip (20) there-between through which said transport path (22) extends, characterised by sealing each said path-defining roller (18) to said housing (10) to ensure said etching cell (12) is a closed etching cell (12).

9. A method according to claim 8, further comprising introducing etching liquid (30) into said etching cell (12), defining an etching liquid level (36) in said etching cell (12), so positioned that said transport path (22) extends at least in part through said etching liquid (30) below said etching liquid level (36), feeding a substrate (46) along said transport path (22) through said etching liquid (30) and discharging used etching liquid (30) from said etching cell (12).

10. A method according to claim 9, further comprising supplying an atmosphere having a controlled composition to a gas space (38) above said etching liquid level (36).
